# EUROPÄISCHE PATENTSCHRIFT

(11) **EP 1 738 042 B1**
(45) Veröffentlichungstag und Bekanntmachung des Hinweises auf die Patenterteilung: **16.01.2008**
(21) Anmeldenummer: 05730390.1
(22) Anmeldetag: 05.04.2005
(51) Int. Cl.: E05B 7/00, E05B 47/00, E05B 65/20

(54) **VORRICHTUNG ZUM BETÄTIGEN EINER ELEKTRISCHEN ODER MECHANISCHEN SCHLIESSEINRICHTUNG AN EINER TÜR UND/ODER EINER KLAPPE EINES FAHRZEUGS**
DEVICE FOR ACTUATING AN ELECTRICAL OR MECHANICAL CLOSURE MECHANISM ON A VEHICLE DOOR AND/OR SHUTTER
DISPOSITIF POUR ACTIONNER UN DISPOSITIF DE FERMETURE ELECTRIQUE OU MECANIQUE SUR UNE PORTE ET/OU UN VOLET D'UN VEHICULE

(30) Priorität: 22.04.2004 DE 102004019571
(43) Veröffentlichungstag der Anmeldung: 03.01.2007
(73) Patentinhaber: Huf Hülsbeck & Fürst GmbH & Co. KG, 42551 Velbert (DE)
(72) Erfinder: WEBER, Franz-Josef, 40699 Erkrath (DE)
(74) Vertreter: Mentzel, Norbert
(86) Internationale Anmeldenummer: PCT/EP2005/003553
(87) Internationale Veröffentlichungsnummer: WO 2005/106163

(56) Entgegenhaltungen:
- EP-A- 0 805 247
- EP-A- 0 954 098
- EP-A- 1 235 190
- WO-A-01/40606
- WO-A-20/04007876
- DE-A1- 10 221 511
- DE-A1- 10 240 828
- DE-A1- 19 617 038
- US-A- 5 844 470

## Beschreibung

Die Erfindung richtet sich auf eine Vorrichtung der im Oberbegriff des Anspruches 1 angegebenen Art. Die Sensoren der Vorrichtung sprechen auf eine Annäherung oder Berührung an.

Die DE 196 17 038 C2 zeigt eine Schließvorrichtung für ein Fahrzeug mit einem kapazitivem Sensor, der nur dann anspricht, wenn sich eine berechtigte Person ihm nähert. Die berechtigte Person ist im Besitz eines Identifikations (ID-Geber), dem ein Identifikationsnehmer (ID-Nehmer) im Fahrzeug zugeordnet ist. Bei Annäherung der Hand an den Sensor erfolgt eine Änderung der Kapazität, die vom Sensor festgestellt wird. Sofern es sich dabei um eine berechtigte Person handelt, beginnt eine Datenkommunikation zwischen dem ID-Geber und dem ID-Nehmer. Die empfangenen Ist-Daten werden mit in einem Speicher enthaltenen Soll-Daten verglichen. Liegt ein erfolgreicher Vergleich vor, so wird die Betätigung der Schließeinrichtung wirksam gesetzt und zwar noch bevor die eigentliche Betätigung einer Handhabe der Schließeinrichtung von der berechtigten Person ausgeführt wird. Die Person, welche die Handhabe betätigt, merkt von dieser Kommunikation und den Datenvergleichen nichts; das Öffnen und Schließen der Tür oder einer Klappe erfolgt ohne Zeitverzug.

Aus der WO 01/40606 A1 ist ein Türschließsystem für Kraftfahrzeuge mit einem Sensor im Türgriff bekannt, der beim Berühren des Türgriffs ein erstes Signal und beim Loslassen des Türgriffs ein zweites Signal erzeugt. Beide Signale werden als Beginn und Ende einer Betätigung des Türgriffs ausgewertet.

Die DE 102 40 828 A1 zeigt eine Vorrichtung der im Oberbegriff des Anspruches 1 angegebenen Art. Die beiden Sensoren sind in Abstand zueinander an unterschiedlichen Stellen eines Türgriffs angeordnet und bestehen entweder aus kapazitiv wirksamen Sensoren oder druckempfindlichen bzw. piezoelektrischen Schaltern.

Damit nicht unnötige, energieverbrauchende Kommunikationen erfolgen, darf ein Sensor nicht auf die Annäherung oder Berührung durch ein beliebiges Objekt ansprechen, sondern nur durch die menschliche Hand. Unerwünscht ist, wenn Betätigungen der Einrichtung durch beliebige äußere Einflüsse herbeigeführt werden, wie Regen, Schnee, Eis oder Blätter. Deswegen ermittelt ein kapazitiver Sensor bei der DE 196 20 059 A1 auch die Geschwindigkeit der Änderung der Kapazität, die sich bei Annäherung oder Berührung mit einem Objekt ergibt. Man nutzt bei dieser bekannten Vorrichtung den Umstand, dass eine Kapazitätsänderung pro Zeiteinheit bei Annäherung einer menschlichen Hand an den Sensor größer ist, als durch Fehlerobjekte. Misst man die Kapazitätsänderung pro Zeiteinheit, so wird eine Betätigung der Schließeinrichtung nur dann wirksam gesetzt, wenn ein bestimmter Grenzwert der zeitlichen Kapazitätsänderung überschritten wird. Diese Methode ist aber nicht in allen Fällen anwendbar.

Der Erfindung liegt die Aufgabe zugrunde, eine zuverlässige Vorrichtung der im Oberbegriff des Anspruches 1 genannten Art zu entwickeln, die eindeutig unterscheidet, ob eine Ansteuerung des Sensors durch eine menschliche Hand oder durch Fehlerobjekte erfolgt und nur dementsprechend eine Umsteuerung des Schlosses bewirkt. Dies wird erfindungsgemäß durch die im Anspruch 1 genannten Maßnahmen erreicht, denen folgende besondere Bedeutung zukommt.

Weil beide Signale für eine erfolgreiche Auswertung erforderlich sind, sind Fehlauslösungen der Schließeinrichtung bei der Erfindung nicht zu befürchten.

Wenn der Hauptsensor eine Annäherung eines Objekts feststellt und ein Signal abgibt, so genügt das noch nicht für eine Umsteuerung des Schlosses; es muss vielmehr gleichzeitig oder wenigstens innerhalb eines bestimmten Zeit-Fensters auch eine Berührung der gemeinsamen nachgiebigen Betätigungsstelle erfolgen, damit ein ausreichender Druck auf das Piezoelement ausgeübt wird und daher auch der Hilfssensor ein Signal abgibt. Bei Berühren der Betätigungsstelle gibt das Piezoelement vom Hilfssensor ein kurzes Einschaltsignal ab und erfasst nicht die Dauer der Berührung. Die Dauer der Berührung wird aber vom Hauptsensor ermittelt. Nach erfolgreicher Auswertung der beiden unterschiedlichen, vom Haupt- und Hilfssensor kommenden Signale wird das Schloss in die Verriegelungsstellung überführt.

Der mit dem Piezoelement wirksame Hilfssensor arbeitet sprunghaft dynamisch und gibt ein kurzes Eingangssignal ab. Die Dauer der Berührung wird dabei nicht erfasst. Die Dauer der Berührung wird aber vom Hauptsensor ermittelt. Das sich aus der Auswertung beider Signale ergebende gemeinsame Ausgangssignal kann dann nicht nur zur vorbeschriebenen Umsteuerung des Schlosses genutzt werden, sondern auch dazu dienen, eine oder mehrere weitere Funktionen im Fahrzeug auszulösen. Ob und welche Funktionen ausgelöst werden, hängt von der Dauer der Berührung ab. Diese weiteren Funktionen können Komfortbetätigungen von beweglichen Bauteilen sein. Dadurch lassen sich geöffnete Fenster des Fahrzeugs schließen, eine Alarmanlage einschalten, ein Verdeck im Fahrzeug schließen und/oder Seitenspiegel vom Fahrzeug einklappen.

Weitere Maßnahmen und Vorteile der Erfindung ergeben sich aus den Unteransprüchen, der nachfolgenden Beschreibung und den Zeichnungen. In den Zeichnungen ist die Erfindung in einem Ausführungsbeispiel schematisch dargestellt. Es zeigen:

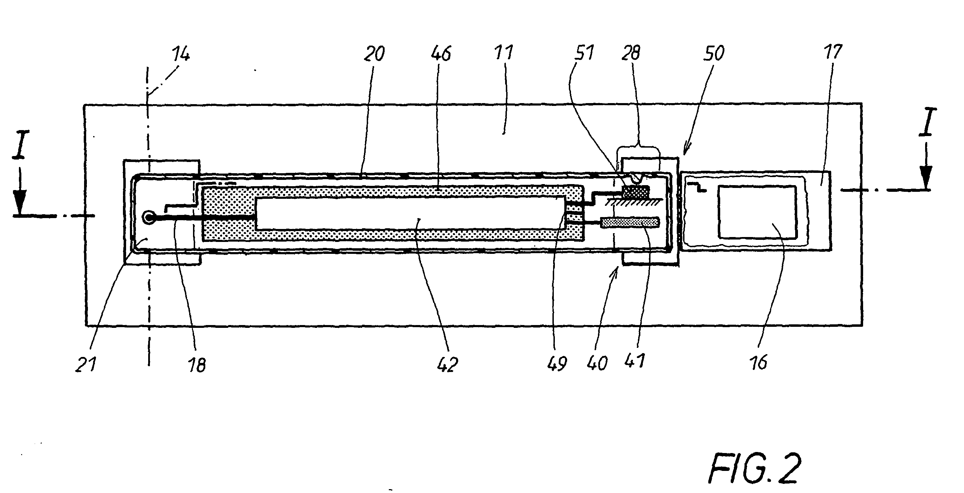

- Fig. 1: einen im wesentlichen horizontalen Längsschnitt durch einen Türaußengriff eines Fahrzeugs, an welchem die erfindungsgemäße Vorrichtung verwirklicht ist, und zwar in Blickrichtung der in Fig. 2 eingezeichneten Schnittlinie I - I,
- Fig. 2: einen vertikalen Längsschnitt durch den in Fig. 1 gezeigten Türaußengriff längs der dortigen Schnittlinie II - II und
- Fig. 3,: in starker Vergrößerung, ein Detail aus dem vertikalen Längsschnitt von Fig. 2 in einer konstruktiv genaueren Darstellung.

Die Schließeinrichtung 10 umfasst einen Träger 11, der im Inneren einer Tür 12 eines nicht näher gezeigten Fahrzeugs befestigt ist. Von der Tür 12 ist strichpunktiert lediglich die Außenverkleidung 13 angedeutet.

Zu der Schließeinrichtung 10 gehört noch eine Handhabe 20. Die Handhabe 20 ist mit ihrem einen Ende 21 im Träger 11 schwenkgelagert. Die Achse 14 der Schwenklagerung erstreckt sich im wesentlichen vertikal, weshalb die Handhabe 20 ein sogenannter "Ziehgriff" ist. Das andere Ende 22 der Handhabe 20 besitzt eine Verlängerung mit einem Hakenende, die einen Durchbruch 15 in der Türaußenverkleidung 13 und im Träger 11 durchsetzt. Das Hakenende der Verlängerung hintergreift ein mechanisches Eingangsglied 31 an einem in der Tür 12 befindlichen Schloss 30.

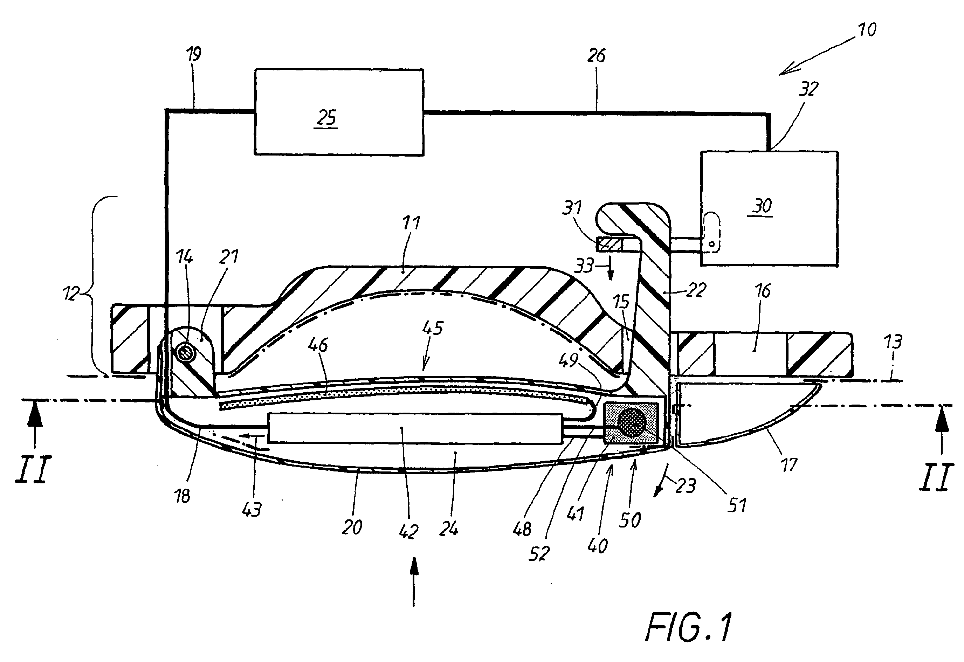

Das Schloss 30 hält die Tür 12 normalerweise in ihrer geschlossenen Position. Das Schloss 30 kann sich wahlweise in einer von zwei Betriebsstellungen befinden, nämlich einer Verriegelungsstellung und einer Entriegelungsstellung. Wird die Handhabe 20 im Sinne des Pfeils 23 von Fig. 1 verschwenkt, so wird über das verlängerte Handhabenende 22 das Schlossglied 31 im Sinne des Mitnahmepfeils 33 von Fig. 1 mitgenommen. Wenn eine Entriegelungsstellung des Schlosses 30 vorliegt, ist diese Betätigung 23 der Handhabe 20 wirksam. Dann gibt das Schloss 30 die Tür frei und die Tür 12 kann geöffnet werden. Liegt dagegen die Verriegelungsstellung des Schlosses 30 vor, so ist die Betätigung 23 unwirksam; das Schlossglied 31 wird im Leerlauf mitgenommen, ohne dass das Schloss 30 die Tür freigibt. Trotz der Betätigung 23 bleibt das Schloss 30 in Verriegelungsstellung in seiner geschlossenen Position.

Die Umsteuerung des Schlosses 30 kann zwar im Notfall mechanisch, z.B. über einen Schließzylinder erfolgen. Das ist zwar nicht näher dargestellt, doch ist ein weiterer Durchbruch 16 im Träger 11 und in der Türaußenverkleidung 13 zu erkennen, in welchem ein solcher Schließzylinder angeordnet sein könnte. Der Schließzylinder ist über einen Notschlüssel betätigbar. Das Stirnende des Schließzylinders, wo der Schlüssel ein- und aussteckbar ist, kann in einer Abdeckung 17 integriert sein, die am Träger 11 befestigt und bündig neben der Handhabe 20 angeordnet ist.

Im Normalfall erfolgt die Umsteuerung des Schlosses 30 zwischen der Entriegelungsstellung und Verriegelungsstellung auf elektrischem Weg. Dazu besitzt das Schloss 30 einen elektrischen Eingang 32. Auslöser für eine solche elektrische Umsteuerung des Schlosses 30 sind drei Sensoren 40, 45 und 50, die unterschiedliche, noch näher zu beschreibende Funktionen ausführen. Im vorliegenden Fall sind alle drei Sensoren 40, 45, 50 im Inneren 24 der Handhabe 20 angeordnet. Im Handhaben-Inneren 24 befinden sich auch elektronische Bauteile 42, die zum Betrieb, zum Steuern und/oder zum Auswerten der von den drei Sensoren 40, 45, 50 kommenden Signale sorgen.

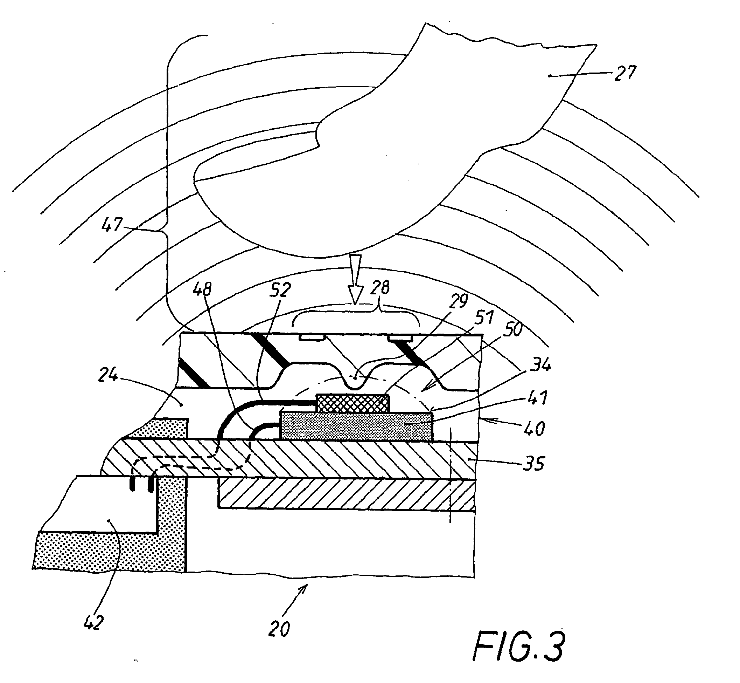

Zwei dieser Sensoren 40, 45 sind im vorliegenden Fall auf kapazitivem Wege wirksam. Von ihnen sind die jeweiligen Elektroden 41, 46 durch unterschiedliche Punktschraffur in den Zeichnungen hervorgehoben. Die Elektroden 41, 46 bauen mit der Karosserie des Fahrzeugs und/oder der Umgebung ein elektrisches Feld auf. Ein solches Feld 47 des kapazitiven Sensors 40 ist in Form von Feldlinien lediglich in Fig. 3 angedeutet. Gelangt ein Objekt, z.B. ein in Fig. 3 erkennbarer Finger 27, in eines der von den beiden Elektroden 41, 46 erzeugten elektrischen Felder, so ändert sich die Kapazität zwischen den Elektroden 41, 46 und dem Fahrzeug bzw. dessen Umgebung. Das wird von den zugehörigen elektrischen Auswerteeinheiten 42 in unterschiedlicher Weise registriert und ausgewertet, was noch näher beschrieben werden wird.

Bei erfolgreicher Auswertung geben die zugehörigen Bauteile 42 ein durch ein Pfeil in Fig. 1 veranschaulichtes Ausgangssignal 43 ab, das über elektrische Leitungen 18 im Bereich der Handhabe 20 und über ein sie verlängerndes elektrisches Kabel 19 in der Tür 12 und im Fahrzeug bis zu einem Steuergerät 25 weitergeleitet wird. Es kann sich dabei um ein zentrales Steuergerät 25 handeln, das über zahlreiche von ihm ausgehende elektrische Verbindungen 26 auf die verschiedenen Schlösser 30 einwirkt, die an den diversen Türen und Klappen des Fahrzeugs vorgesehen sind. Die elektrische Verbindung 26 ist an dem bereits erwähnten elektrischen Eingang 32 des jeweiligen Schlosses 30 angeschlossen. Anstelle einer elektrischen Verbindung 26 könnte das Steuergerät 25 auch mechanisch auf ein zweites, nicht näher gezeigtes Eingangsglied des Schlosses 30 einwirken.

Die beiden kapazitiv wirksamen Sensoren 40, 45 wirken voneinander unabhängig und in zueinander unterschiedlicher Weise. Der eine kapazitive Sensor 45 ist besonders empfindlich eingestellt und wirkt in bekannter Weise auf die Annäherung eines Objekts, insbesondere einer berechtigten Person. Dieser Sensor 45 dient dazu, um ein verriegeltes Schloss 30 zu entriegeln und damit, wie bereits beschrieben wurde, die Handhabe 20 erfolgreich betätigbar 23 zu maschen. Dies findet aber nur dann statt, wenn noch folgende weitere Bedingung erfüllt ist.

Eine solche weitere Bedingung für das Umschalten des Schlosses 30 ergibt sich aus dem Umstand, dass nur berechtigten Personen der Zutritt zum Fahrzeug gewährt werden soll, nicht aber unberechtigten Personen. Die berechtigte Person trägt einen Identifikationsgeber bei sich, der nachfolgend kurz "ID-Geber" bezeichnet werden soll und dem ein entsprechender Identifikationsnehmer im Fahrzeug zugeordnet ist, der analog "ID-Nehmer" genannt werden soll. Normalerweise wirkt ein solcher ID-Geber passiv, einfach durch die Annäherung der berechtigten Person an das Fahrzeug, ohne dass die Person am ID-Geber oder mit dem ID-Geber aktiv werden muss. Es ist aber auch ein aktiver ID-Geber denkbar, wie z.B. ein elektronischer Fernbedienungsschlüssel, der, um wirksam zu werden, durch eine Taste bedient werden muss. In beiden Fällen findet eine mono- oder bilaterale Kommunikation mit dem ID-Nehmer statt. Ist diese Kommunikation erfolgreich, so wird auch dies dem Steuergerät 25 gemeldet, das auch die weitere Bedingung für das Umschalten empfängt und dann über die genannte elektrische oder mechanische Verbindung 26 das Schloss 30 in seine bereits erwähnte Entriegelungsstellung überführt. Wird dann die Handhabe 20 tatsächlich im Sinne des Pfeils 23 von Fig. 1 betätigt, so gibt das Schloss 30 die Tür 12 frei. Die Tür kann geöffnet werden. Deshalb soll dieser zweite kapazitive Sensor 45 "Öffnungssensor" bezeichnet werden. Dieser Öffnungssensor ist nicht Gegenstand der vorliegenden Erfindung.

Der genannte erste kapazitive Sensor 40 ist gegenüber dem Öffnungssensor unempfindlicher gemacht und soll nachfolgend "Hauptsensor" bezeichnet werden. Der Hauptsensor 40 ist nur in Abstimmung mit dem erwähnten dritten Sensor 50 wirkfähig, der "Hilfssensor" genannt werden soll. Dieser Hilfssensor 50 besitzt als Sensorelement ein auf mechanischem Druck ansprechendes Piezoelement 51. Das Piezoelement 51 ist über der Elektrode 41 des Hauptsensors 40 angeordnet. Wie Fig. 3 verdeutlicht, kann die Elektrode 41 sogar die Auflage für das Piezoelement 51 sein und sich selbst dabei auf einer Platine 35 abstützen. Die Leiterbahnen in der Platine 35 können die in Fig. 1 mit 52 und 48 gekennzeichneten elektrischen Verbindungen des Piezoelements 51 und der Elektrode 41 enthalten, was auch für die analoge elektrische Verbindung 49 der Elektrode 46 vom Öffnungssensor 45 gilt. Die Platine 35 dient auch als Träger der diversen elektrischen Auswerteeinheiten 42 der drei Sensoren 40, 50, 45.

Die Handhabe 20 hat, wie am besten aus Fig. 3 hervorgeht, eine nachgiebige Wand bei 28, die zur Berührung dient und daher "Betätigungsstelle" des Haupt- und Hilfssensors 40, 50 bezeichnet werden soll. Zwecks wirkungsvoller Druckausübung kann auf der Innenseite dieser Betätigungsstelle 28 ein Zapfen 29 angeordnet sein, der gezielt einem Druck auf das darunter liegende Piezoelement 51 ausüben soll. Das Piezoelement 51 und die Elektrode 41 können eine vormontierbare Baueinheit bilden, die gemeinsam an der Platine 35 sitzen. So kann die Elektrode 41 seitliche rückgebogene Ränder 34 aufweisen, die in Fig. 3 strichpunktiert angedeutet sind. Diese Elektroden-Ränder 34 umgreifen das auf der Elektrode 41 sich abstützende Piezoelement 51 und sichern so dessen Position.

Weil der Hauptsensor 40 und der Hilfssensor 50 an der gleichen Betätigungsstelle 28 angeordnet sind, liegen sie bei Berührung der Handhabe 20 im gleichen Wirkbereich durch den in Fig. 3 gezeigten Finger 27. Wegen seiner kapazitiven Fernwirkung kann dabei der Hauptsensor 40 bereits bei Annäherung des Fingers wirksam werden, spätestens aber bei der tatsächlichen Berührung der Betätigungsstelle 28. Dann geben der Haupt- und der Hilfssensor zwar ihre eigenen Signale an ihren Steuer- und Auswerteeinheiten 42 ab, doch werden beide Signale gemeinsam ausgewertet. Erst wenn beide Signale von den Auswerteeinheiten 42 für ordnungsgemäß festgestellt worden sind, wird ein Ausgangssignal 43 generiert, das, wie bereits erwähnt wurde, dem Steuergerät 25 zugeführt wird. Das Steuergerät 25 bewirkt im Erfolgsfall die bereits genannte Umsteuerung des Schlosses 30 in seine Verriegelungsstellung.

Beim Berühren der Betätigungsstelle 28 gibt das Piezoelement 51 vom Hilfssensor 50 nur ein kurzes Einschaltsignal ab. Die Dauer der Berührung wird dabei nicht erfasst. Die Dauer der Berührung wird aber von dem kapazitiven Hauptsensor 40 ermittelt und ergibt ein entsprechend modifiziertes Ausgangssignal 43. In Abhängigkeit von der Berührungsdauer können dann, außer der bereits erwähnten Umsteuerung des Schlosses 30, eine oder mehrere weitere Funktionen im Fahrzeug ausgelöst werden. Diese sind vor allem für eine sogenannte Komfortbetätigung von beweglichen Bauteilen im Fahrzeug von Vorteil. Welche Komfortfunktionen dabei sich ergeben wurde bereits oben beispielsweise angegeben.

### Bezugszeichenliste:

- 10: Einrichtung, Schließeinrichtung
- 11: Träger
- 12: Tür
- 13: Außenverkleidung von 12
- 14: Schwenklager von 20 an 11
- 15: Durchbruch in 11 für 22
- 16: Durchbruch in 11 für Schließzylinder
- 17: Abdeckung von 11
- 18: elektrische Leitung für 43 in 20
- 19: elektrisches Kabel für 43
- 20: Handhabe
- 21: erstes Ende von 20
- 22: zweites Ende von 20
- 23: Pfeil der Schwenkbewegung von 20, Betätigung
- 24: Inneres von 20
- 25: Steuergerät
- 26: elektrische Verbindung
- 27: menschlicher Finger (Fig. 3)
- 28: nachgiebige Wand von 20, Betätigungsstelle
- 29: Zapfen bei 28 für 51 (Fig. 3)
- 30: Schloss
- 31: mechanisches Eingangsglied von 30, Schlossglied
- 32: elektrischer Eingang von 30
- 33: Pfeil der Mitnahmebewegung von 31
- 34: Rand von 41 (Fig. 3)
- 35: Platine in 24 (Fig. 3)

- 40: erster Sensor zum Verriegeln von 30, Hauptsensor
- 41: Elektrode von 40
- 42: elektrische Bauteile, Auswerteeinheiten für 40, 50, 45
- 43: Pfeil eines elektrischen Ausgangssignals von 42 an 25 (Fig. 1)

- 45: zweiter kapazitiver Sensor zum Entriegeln von 30, Öffnungssensor
- 46: Elektrode von 45
- 47: elektrisches Feld von 40 (Fig. 3)
- 48: elektrische Verbindung von 41 mit 42
- 49: elektrische Verbindung von 46 mit 42
- 50: Hilfssensor
- 51: Piezoelement von 50
- 52: elektrische Verbindung von 51 mit 42

## Patentansprüche

1. Vorrichtung zum Betätigen einer elektrischen oder elektromechanischen Schließeinrichtung (10) an einer Tür (12) und/oder einer Klappe eines Fahrzeugs,
mit einer Handhabe (20), die zum Öffnen und/oder zum Schließen eines an der Tür (12) und/oder Klappe vorgesehenen Schlosses (30) dient,
mit mindestens zwei Sensoren (40, 50), die bei Annäherung oder Berührung zwar getrennte Signale abgeben, beide Signale aber gemeinsam von einer Auswerteeinheit (42) der Vorrichtung ausgewertet werden, mit der Folge,
dass das Schloss (30) zwischen einer Entriegelungsstellung und einer Verriegelungsstellung umgesteuert wird,
wobei in der Entriegelungsstellung die Betätigung der Handhabe (20) für das Schloss (30) wirksam, aber in der Verriegelungsstellung unwirksam ist,
**dadurch gekennzeichnet,**
**dass** die beiden Sensoren zueinander unterschiedlich ausgebildet sind und der eine aus einem kapazitiv wirkenden Hauptsensor (40) und der andere aus einem als Piezoelement (51) gestalteten Hilfssensor (50) bestehen und im Wirkbereich einer Betätigungsstelle (28) angeordnet sind,
**dass** an der Betätigungsstelle eine nachgiebige Wand (28) angeordnet ist, die den piezoelektrischen (51) Hilfssensor (50) überdeckt und bei Berührung einen Druck auf das Piezoelement (51) ausübt,
**dass** beim Berühren der Betätigungsstelle (28) das Piezoelement (51) vom Hilfssensor (50) ein kurzes Einschaltsignal abgibt, ohne die Dauer der Berührung zu erfassen,
**dass** aber die Dauer der Berührung vom Hauptsensor (40) von der Auswerteeinheit (42) ermittelt wird,
und **dass** eine erfolgreiche Auswertung (43) der vom Haupt- und Hilfssensor (40, 50) kommenden Signale das Schloss (30) in dessen Verriegelungsstellung überführt.

2. Vorrichtung nach Anspruch 1, **dadurch gekennzeichnet, dass** der Hauptsensor (40), neben der Umsteuerung des Schlosses (30), in Abhängigkeit von der Berührungs-Dauer noch eine oder mehrere weitere Funktionen im Fahrzeug auslöst.

3. Vorrichtung nach Anspruch 2, **dadurch gekennzeichnet, dass** die weiteren Funktionen im Fahrzeug Komfortbetätigungen von beweglichen Bauteilen im Fahrzeug sind.

4. Vorrichtung nach Anspruch 3, **dadurch gekennzeichnet, dass** die Komfortfunktionen darin bestehen, wenigstens ein geöffnetes Fenster im Fahrzeug zu schließen und/oder eine Alarmanlage einzuschalten und/oder ein Verdeck im Fahrzeug zu schließen und/oder die Seitenspiegel vom Fahrzeug einzuklappen.

5. Vorrichtung nach einem der Ansprüche 1 bis 4, **dadurch gekennzeichnet, dass** wenigstens eine kapazitive Elektrode (41) des Hauptsensors (40), das Piezoelement (51) des Hilfssensors (50) und die nachgiebige Betätigungsstelle (28) in bzw. an der Handhabe (20) der Schließeinrichtung (10) angeordnet sind.

6. Vorrichtung nach einem der Ansprüche 1 bis 4, **dadurch gekennzeichnet, dass** außer dem zur Verriegelung des Schlosses (30) dienenden Haupt- und Hilfssensor (40, 50) noch ein Öffnungssensor (45) vorgesehen ist, der bei einer Annäherung oder Berührung das Schloss (30) in seine Entriegelungsstellung überführt werden kann.

7. Vorrichtung nach Anspruch 6, **dadurch gekennzeichnet, dass** der Öffnungssensor (45) in der Handhabe (20) angeordnet ist.

8. Vorrichtung nach einem der Ansprüche 5 bis 7, **dadurch gekennzeichnet, dass** wenigstens ein elektrischer Bauteil der Auswerteeinheit (42) zum Betrieb, zum Steuern und/oder zum Auswerten der Signale vom Haupt- und/oder Hilfssensor (40, 50) und der vom Öffnungssensor (45) kommenden Signale in der Handhabe (20) angeordnet sind.

9. Vorrichtung nach einem der Ansprüche 1 bis 8, **dadurch gekennzeichnet, dass** ein Steuergerät (25) die Umsteuerung des Schlosses (30) zwischen der Entriegelungsstellung und der Verriegelungsstellung nur dann bewirkt, wenn die Berührung des Haupt- und Hilfssensors (40, 50) durch eine berechtigte Person erfolgt.

10. Vorrichtung nach Anspruch 9, **dadurch gekennzeichnet, dass** die berechtigte Person einen aktiven oder passiven Identifikationsgeber, der als ID-Geber bezeichnet werden kann, bei sich hat,
dass der ID-Geber mit einem Identifikationsnehmer, der als ID-Nehmer benannt werden kann, im Fahrzeug kommuniziert
und dass bei erfolgreicher Kommunikation zwischen dem ID-Geber und dem ID-Nehmer die Betätigung (23) der Einrichtung (10) freigeschaltet wird.

## Claims

1. Device for actuating an electrical or electromechanical closure device (10) on a vehicle door (12) or shutter,
with a handle (20) that serves to open and/or to close a lock (30) provided on the door (12) and/or shutter,
with at least two sensors (40, 50) that when approached or touched output separate signals but with both signals being jointly evaluated by an evaluation unit (42) of the device, with the result,
that the lock (30) is between from an unlocking position and a locking position,
with the actuation of the handle (20) being effective for the lock (30) in the unlocking position but ineffective in the locking position,
**characterized in that**
the two sensors are designed differently from each other with the main sensor (40) operating on capacitance and the other being an auxiliary sensor (50) designed as a piezo element (51) and arranged in the effective range of the actuating point (28),
a flexible wall (28) is arranged at the actuating point, with said flexible wall (28) covering the piezoelectric (51) auxiliary sensor (50) and exerting a pressure on the piezo element (51) on contact,
that when the actuating point (28) is contacted the piezo element (51) outputs a short switch-on signal from the auxiliary sensor (50) without detecting the duration of the contact,
but with the duration of contact of the main sensor (40) being determined by the evaluation unit (42)
and that a successful evaluation (43) of the signals coming from the main and auxiliary sensors (40, 50) changes the lock (30) to its locking position.

2. Device according to Claim 1, **characterized in that** the main sensor (40) activates one or more further functions in the vehicle depending on the contact duration, in addition to changing over the lock (30).

3. Device according to Claim 2, **characterized in that** the further functions in the vehicle are convenient actuations of moveable components in the vehicle.

4. Device according to Claim 3, **characterized in that** the convenient functions are at least closing an opened window in the vehicle and/or switching on an alarm system and/or closing a top in the vehicle and/or folding back the side mirrors of the vehicle.

5. Device according to one of Claims 1 to 4, **characterized in that** at least one capacitive electrode (41) of the main sensor (40), the piezo element (51) of the auxiliary sensor (50) and the flexible actuating point (28) are arranged in or on the handle (20) of the closure device (10).

6. Device according to one of Claims 1 to 4, **characterized in that** in addition to the main and auxiliary sensors (40, 50) used for locking the lock (30), an opening sensor (45) is also provided that when approached or contacted can move the lock (30) to its unlocking position.

7. Device according to Claim 6, **characterized in that** the opening sensor (45) is arranged in the handle (20).

8. Device according to one of Claims 5 to 7, **characterized in that** at least one electrical component of the evaluation unit (42) for controlling and/or evaluating the signals from the main and/or auxiliary sensors (40, 50) and the signals coming from the opening sensor (45) is arranged in the handle (20).

9. Device according to one of Claims 1 to 8, **characterized in that** a control unit(25) changes the lock (30) between the unlocking position and locking position only if the contact with the main and auxiliary sensors (40, 50) takes place by an authorized person.

10. Device according to Claim 9, **characterized in that** the authorized person has an active or passive identification transmitter that can be designated an ID transmitter,
that the ID transmitter communicates with an identification receiver in the vehicle that can be designated an ID receiver,
and that in the event of successful communication between the ID transmitter and ID receiver the actuation (23) of the device (10) is enabled.

## Revendications

1. Dispositif pour actionner un dispositif de fermeture (10) électrique ou électromécanique sur une portière (12) et/ou un volet d'un véhicule,
avec une manette (20), servant à l'ouverture et/ou à la fermeture d'une serrure (30) prévue sur la portière (12) et/ou le volet,
avec au moins deux capteurs (40, 50) qui, en cas d'approche ou de contact, fournissent certes des signaux séparés, les deux signaux cependant étant évalués conjointement par une unité d'évaluation (42) du dispositif, avec comme conséquence que
la serrure (30) est commandée pour être commutée entre une position de déverrouillage et une position de verrouillage,
à la position de déverrouillage, l'actionnement de la manette (20) pour la serrure (30) étant opérant, mais étant inopérant à la position de verrouillage,
***caractérisé en ce que***
les deux capteurs sont réalisés différemment l'un de l'autre et un premier capteur principal (40) agit par voie capacitive, et l'autre capteur auxiliaire (50) est configuré en tant que piézoélément (51) et est disposé dans la zone active d'un point d'actionnement (28),
**en ce qu'**au point d'actionnement est disposée une paroi (28) déformable, couvrant le capteur auxiliaire (50) piézoélectrique (51) et exerçant en cas de contact une pression sur le piézoélément (51),
**en ce que**, en cas de contact du point d'actionnement (28), le piézoélément (51) du capteur auxiliaire (50) fournit un bref signal de mise en service sans détecter la durée du contact,
**en ce que**, cependant, la durée du contact du capteur principal (40) est déterminée par l'unité d'évaluation (42),
et **en ce qu'**une évaluation (43), couronnée de succès, des signaux provenant des capteurs principaux et auxiliaires (40, 50) fait passer la serrure (30) à sa position de verrouillage.

2. Dispositif selon la revendication 1, **caractérisé en ce que** le capteur principal (40), outre la commande de commutation de la serrure (30), en fonction de la durée du contact déclenche encore une ou plusieurs autre(s) fonction(s) dans le véhicule.

3. Dispositif selon la revendication 2, **caractérisé en ce que** les autres fonctions dans le véhicule sont des actionnements de confort de composants mobiles.

4. Dispositif selon la revendication 3, **caractérisé en ce que** les fonctions de confort consistent à fermer au moins une fenêtre ouverte dans le véhicule et/ou à mettre en service une installation d'alarme et/ou à fermer une capote dans le véhicule et/ou à rabattre les rétroviseurs latéraux du véhicule.

5. Dispositif selon l'une des revendications 1 à 4, **caractérisé en ce qu'**au moins une électrode capacitive (41) du capteur principal (40), le piézoélément (51) du capteur auxiliaire (50) et le point d'actionnement (28) déformable, sont disposés dans ou sur la manette (20) du dispositif de fermeture (10).

6. Dispositif selon l'une des revendications 1 à 4, **caractérisé en ce que**, outre les capteurs principaux et auxiliaires (40, 50) servant au verrouillage de la serrure (30), est encore prévu un capteur d'ouverture (45), qui, en cas d'approche ou de contact, peut faire passer la serrure (30) à sa position de déverrouillage.

7. Dispositif selon la revendication 6, **caractérisé en ce que** le capteur d'ouverture (45) est disposé dans la manette (20).

8. Dispositif selon l'une des revendications 5 à 7, **caractérisé en ce qu'**au moins un composant électrique de l'unité d'évaluation (42), pour le fonctionnement, pour la commande et/ou pour l'évaluation des signaux provenant du capteur principal et/ou auxiliaire (40, 50) et des signaux provenant du capteur d'ouverture (45), sont disposés dans la manette (20).

9. Dispositif selon l'une des revendications 1 à 8, **caractérisé en ce qu'**un appareil de commande (25) provoque la commande de commutation de la serrure (30), entre la position de déverrouillage et la position de verrouillage, uniquement lorsque le contact des capteurs principaux et auxiliaires (40, 50) est effectué par une personne autorisée.

10. Dispositif selon la revendication 9, **caractérisé en ce que** la personne autorisée dispose sur soi d'un émetteur d'identification actif ou passif, pouvant être qualifié d'émetteur d'ID,
**en ce que** l'émetteur d'ID communique dans le véhicule avec un récepteur d'identification, pouvant être qualifié de récepteur d'ID,
et **en ce que** lorsque la communication réussit entre l'émetteur d'ID et le récepteur d'ID, l'actionnement (23) du dispositif (10) est déclenché.
